# EUROPÄISCHE PATENTSCHRIFT

(11) **EP 3 107 161 B1**
(45) Veröffentlichungstag und Bekanntmachung des Hinweises auf die Patenterteilung: **03.01.2018**
(21) Anmeldenummer: 16182390.1
(22) Anmeldetag: 20.11.2001
(51) Int. Cl.: H01S 5/40

(54) **ÜBEREINANDER GESTAPELTE HALBLEITER-DIODENLASER**
STACKED SEMICONDUCTOR LASER DIODE
LASERS A DIODE A SEMI-CONDUCTEURS EPILES LES UNS SUR LES AUTRES

(30) Priorität: 21.11.2000 DE 10057698
(43) Veröffentlichungstag der Anmeldung: 21.12.2016
(62) Teilanmeldung aus: 01997871.7
(73) Patentinhaber: Osram Opto Semiconductors Gmbh, 93055 Regensburg (DE)
(72) Erfinder: BEHRINGER, Martin Rudolf, 93049 Regensburg (DE); LUFT, Johann, 93195 Wolfsegg (DE); EBELING, Karl, 89075 Ulm (DE); KNÖDL, Thomas, 88094 Oberteuringen (DE)
(74) Vertreter: Epping - Hermann - Fischer

(56) Entgegenhaltungen:
- EP-A- 0 803 948
- JP-A- H08 139 404
- US-A- 5 212 706
- US-A- 6 144 683
- KIM J K ET AL: "NEAR-ROOM-TEMPERATURE CONTINUOUS-WAVE OPERATION OF MULTIPLE-ACTIVE-REGION 1.55 MUM VERTICAL-CAVITY LASERS WITH HIGH DIFFERENTIAL EFFICIENCY", APPLIED PHYSICS LETTERS, AMERICAN INSTITUTE OF PHYSICS. NEW YORK, US, Bd. 77, Nr. 20, 13. November 2000 (2000-11-13), Seiten 3137-3139, XP000970279, ISSN: 0003-6951
- BOUR D P ET AL: "INFRA-RED ALGAAS AND VISIBLE ALGAINP PASER-DIODE STACK", ELECTRONICS LETTERS, IEE STEVENAGE, GB, Bd. 29, Nr. 21, 14. Oktober 1993 (1993-10-14), XP000404316, ISSN: 0013-5194

## Beschreibung

Die vorliegende Erfindung betrifft übereinander gestapelte Halbleiter-Diodenlaser.

Hochleistungs-Diodenlaser, die eine hohe Leistung emittieren, belasten die Facetten der einzelnen Kristallschichten bis in den Grenzbereich. Um die erreichbare Leistung eines Diodenlasers zu erhöhen, können zwei Diodenlaser monolithisch übereinander integriert werden. Dazu werden entsprechende Schichten übereinandergewachsen. Der Kontakt zwischen zwei übereinander gewachsenen Diodenlasern wird, wie in dem Patent US 5,212,706 beschrieben, beispielsweise durch eine hoch dotierte Tunneldiode erreicht, die in Sperrrichtung gepolt ist. Die Tunneldiode ist extremen Belastungen in Bezug auf die durch sie fließende Stromstärke ausgesetzt und kann durch die vorherrschenden Belastungen zerstört werden. Ein weiteres Beispiel für einen Tunnelkontakt ist in dem Patent US 5,679,963 angegeben.

Die Laserdioden werden üblicherweise aus einer Reihe von Schichten aufgewachsen, wobei die einzelnen Schichten unterschiedliche Materialien und folglich unterschiedliche Gitterkonstanten aufweisen können. Die unterschiedlichen Gitterkonstanten zwischen benachbarten Schichten führen zu Verspannungen, so daß in dem Schichtstapel elastische Energie gespeichert wird und Kräfte zwischen benachbarten Schichten wirken. Ist die zwischen zwei Schichten wirkende Kraft zu groß, so entstehen Gitterversetzungen in oder zwischen den entsprechenden Schichten, wodurch die Diodenlaser unbrauchbar werden können. Patentschrift US6144683 ist ein Stapel von zwei auf einem Substrat gewachsenen Laserdioden mit einer Zwischenschicht zu entnehmen. Es ist die Aufgabe der Erfindung, einen verbesserten Kontakt zwischen zwei übereinander angeordneten Diodenlasern anzugeben. Beispielsweise gibt es eine Anordnung übereinander gestapelter Halbleiter-Diodenlaser mit:
- einem Substrat, auf dem ein erster Diodenlaser angeordnet ist;
- einem zweiten Diodenlaser, der auf dem ersten Diodenlaser angeordnet ist;
- einer Kontaktschicht, die zwischen dem ersten Diodenlaser und dem zweiten Diodenlaser angeordnet ist, wobei die Kontaktschicht eine erste leitfähige Schicht eines ersten Leitungstyps, eine zweite leitfähige Schicht eines zweiten Leitungstyps und eine Zwischenschicht umfaßt, wobei die Zwischenschicht zwischen der ersten und der zweiten leitfähigen Schicht angeordnet ist und die Tunnelwahrscheinlichkeit für Ladungsträger erhöht.

Die Zwischenschicht weist den Vorteil auf, daß die Ladungsträger-Absorption und die Streuung an ionisierten Störstellen in ihr reduziert ist, so daß die Ladungsträger höhere Lebensdauern aufweisen und somit der elektrische Widerstand vermindert ist. Der verminderte elektrische Widerstand führt dazu, daß der leitfähige Kontakt auch bei extremen Strombelastungen stabil bleibt und nicht zerstört wird. Dadurch wird die Lebensdauer der Diodenlaser-Anordnung in vorteilhafter Weise verlängert.

In einer Ausgestaltung ist vorgesehen, daß die Zwischenschicht undotiert ist. Eine undotierte (intrinsische) Schicht hat den Vorteil, daß die Ladungsträger-Absorption und die Streuung von Ladungsträgern an ionisierten Störstellen im unmittelbaren Übergangsbereich reduziert ist. Dadurch besitzen die Ladungsträger eine erhöhte Lebensdauer, so daß der elektrische Widerstand der leitfähigen Kontaktschicht reduziert ist. In vorteilhafter Weise wird die Zwischenschicht relativ dünn ausgebildet. Sie kann eine Dicke zwischen einer Monolage und 50 nm aufweisen.

Eine weitere Anordnung sieht vor, daß die Zwischenschicht mit dem ersten oder dem zweiten Leitungstyp dotiert ist, jedoch eine niedrigere Dotierstoffkonzentration aufweist, als die erste oder die zweite leitfähige Schicht. Eine weitere Anordnung umfasst eine Anordnung übereinander gestapelter Halbleiter-Diodenlaser mit:
- einem Substrat, auf dem ein erster Diodenlaser angeordnet ist;
- einem zweiten Diodenlaser, der auf dem ersten Diodenlaser angeordnet ist;
- einer Kontaktschicht, die zwischen dem ersten Diodenlaser und dem zweiten Diodenlaser angeordnet ist, wobei die Kontaktschicht eine erste leitfähige Schicht eines ersten Leitungstyps, eine zweite leitfähige Schicht eines zweiten Leitungstyps, eine erste Zwischenschicht und eine zweite Zwischenschicht aufweist, wobei die erste und die zweite Zwischenschicht zwischen der ersten und zweiten leitfähigen Schicht angeordnet sind, und die erste Zwischenschicht der ersten leitfähigen Schicht und die zweite Zwischenschicht der zweiten leitfähigen Schicht zugewandt ist.

Die erste und die zweite Zwischenschicht ermöglichen Quantenphänomene, da durch sie die Bandstruktur so modifiziert ist, daß Quantentrog-ähnliche Modifikationen des Ferminiveaus auftreten. Beispielsweise ist die effektiv erreichbare Dotierung in der ersten und zweiten Zwischenschicht gegenüber Bulk-Material erhöht. Durch die erhöhte effektive Dotierung ist beispielsweise die Ladungsträgerdichte ebenfalls erhöht, wodurch der elektrische Kontakt einen reduzierten Kontaktwiderstand aufweist.

Eine Anordnung sieht vor, daß die erste Zwischenschicht den gleichen Leitungstyp wie die erste leitfähige Schicht aufweist, jedoch eine höhere Dotierstoffkonzentration besitzt und die zweite Zwischenschicht den gleichen Leitungstyp wie die zweite leitfähige Schicht aufweist, jedoch eine höhere Dotierstoffkonzentration besitzt. Die erhöhte Dotierstoffkonzentration der ersten und zweiten Zwischenschicht ermöglicht es, eine erhöhte Ladungsträgerdichte gegenüber herkömmlichen pn-Tunnel-Kontakten zu erreichen, wodurch der Kontaktwiderstand des elektrischen Kontaktes reduziert ist.

Weiterhin ist vorzugsweise vorgesehen, daß die erste und/oder die zweite Zwischenschicht eine Dicke zwischen einer Monolage und 30 nm, beziehungsweise zwischen 4 nm und 12 nm aufweist. Eine Dicke zwischen einer Monolage und 30 nm ermöglicht die Ausbildung von Quantentrog-ähnlichen Strukturen, wodurch Quantenphänomene ermöglicht werden, die eine erhöhte effektiv erreichbare Dotierung und damit eine erhöhte Ladungsträgerdichte gegenüber herkömmlichen Strukturen ermöglichen. Eine Dicke zwischen 4 und 12 nm ist in vorteilhafter Weise dazu geeignet, Quantentrog-ähnliche Strukturen auszubilden.

Die erfindungsgemäße Aufgabe wird gelöst durch eine Anordnung übereinander gestapelter Halbleiter-Diodenlaser mit:
- einem Substrat, auf dem ein erster Diodenlaser angeordnet ist;
- einem zweiten Diodenlaser, der auf dem ersten Diodenlaser angeordnet ist;
- einer Kontaktschicht, die zwischen dem ersten Diodenlaser und dem zweiten Diodenlaser angeordnet ist, wobei die Kontaktschicht so ausgebildet ist, daß eine Gitterfehlanpassung zwischen dem Substrat und dem ersten Diodenlaser durch eine Gitterfehlanpassung mit entgegengesetztem Vorzeichen zwischen dem Substrat und der Kontaktschicht kompensierbar ist.

Die kompensierbare Materialverspannung erhöht in vorteilhafter Weise die Lebensdauer der Halbleiter-Diodenlaser-Anordnung, da Verspannungen in dem Schichtstapel kompensiert werden und somit Relaxationsversetzungen nicht entstehen. Durch den Abbau von Gitterspannungen wird eine Kumulation von elastischer Energie verhindert, wodurch die Lebensdauer und die elektrische Belastbarkeit des elektrischen Kontakts verbessert wird.

Weiterhin ist vorgesehen, daß das Substrat eine erste Gitterkonstante, der erste Diodenlaser eine zweite Gitterkonstante und die Kontaktschicht eine dritte Gitterkonstante aufweist, wobei die Differenz von zweiter Gitterkonstante minus erster Gitterkonstante das gleiche Vorzeichen hat wie die Differenz von erster Gitterkonstante minus dritter Gitterkonstante. Durch das gleiche Vorzeichen in der Differenz der angegebenen Gitterkonstanten wird gewährleistet, daß die Verspannung zwischen Substrat und Diodenlaser durch eine Verspannung zwischen Substrat und Kontaktschicht teilweise oder gänzlich kompensiert wird. Weist beispielsweise die Laserstruktur eine größere Gitterkonstante als das Substrat auf, so sollte die Kontaktschicht eine kleinere Gitterkonstante als das Substrat aufweisen. Im Falle, daß die Laserstruktur eine kleinere Gitterkonstante als das Substrat aufweist, so sollte die Kontaktschicht eine größere Gitterkonstante als das Substrat aufweisen

Eine weitere Ausgestaltung der Erfindung sieht vor, daß die Kontaktschicht Galliumphosphid, Indiumgalliumphosphid, Zinksulfid, Zinktellurid, Zinksulfidtellurid, Zinkselenid, Zinksulfidselenid oder Indiumgalliumarsenphosphid enthält. Geeignet ist beispielsweise Aluminium-Gallium-Indium-Arsenid-Nitrid-Phosphid Die genannten Materialien sind in vorteilhafter Weise dazu geeignet, die Gitterverspannungen zwischen dem ersten Diodenlaser und dem Substrat mittels entgegengesetzter Gitterfehlanpassung zwischen der Kontaktschicht und dem Substrat zu kompensieren.

Weitere vorteilhafte Ausgestaltungen sind Gegenstand der jeweiligen Unteransprüche.

Die Anordnung kann sich insbesondere durch mindestens einen der folgenden Aspekte auszeichnen, welche zur vereinfachten Darstellung nummeriert und mit Rückbezügen versehen sind.
1. Anordnung übereinander gestapelter Halbleiter-Diodenlaser mit:
   - einem Substrat (1), auf dem ein erster Diodenlaser (12) angeordnet ist;
   - einem zweiten Diodenlaser (13), der auf dem ersten Diodenlaser (12) angeordnet ist;
   - einer Kontaktschicht (6), die zwischen dem ersten Diodenlaser (12) und dem zweiten Diodenlaser (13) angeordnet ist,
   dadurch gekennzeichnet, daß
   die Kontaktschicht (6) eine erste leitfähige Schicht (18) eines ersten Leitungstyps, eine zweite leitfähige Schicht (20) eines zweiten Leitungstyps und eine Zwischenschicht (19) umfaßt, wobei die Zwischenschicht (19) zwischen der ersten und zweiten leitfähigen Schicht (18, 20) angeordnet ist und die Tunnelwahrscheinlichkeit für Ladungsträger erhöht.
2. Anordnung nach Aspekt 1,
   dadurch gekennzeichnet, daß
   die Zwischenschicht (19) undotiert ist.
3. Anordnung nach Aspekt 1,
   dadurch gekennzeichnet, daß
   die Zwischenschicht (19) mit dem ersten oder dem zweiten Leitungstyp dotiert ist, jedoch eine niedrigere Dotierstoffkonzentration aufweist, als die erste leitfähige Schicht (18) oder die zweite leitfähige Schicht (20).
4. Anordnung übereinander gestapelter Halbleiter-Diodenlaser mit:
   - einem Substrat (1), auf dem ein erster Diodenlaser (12) angeordnet ist;
   - einem zweiten Diodenlaser (13), der auf dem ersten Diodenlaser (12) angeordnet ist;
   - einer Kontaktschicht (6), die zwischen dem ersten Diodenlaser (12) und dem zweiten Diodenlaser (13) angeordnet ist,
   dadurch gekennzeichnet, daß
   die Kontaktschicht (6) eine erste leitfähige Schicht (21) eines ersten Leitungstyps, eine zweite leitfähige Schicht (24) eines zweiten Leitungstyps, eine erste Zwischenschicht (22) und eine zweite Zwischenschicht (23) aufweist, wobei die erste und die zweite Zwischenschicht (22, 23) zwischen der ersten und zweiten leitfähigen Schicht (21, 24) angeordnet sind und die erste Zwischenschicht (22) der ersten leitfähigen Schicht (21) und die zweite Zwischenschicht (23) der zweiten leitfähigen Schicht (24) zugewandt ist.
5. Anordnung nach Aspekt 4,
   dadurch gekennzeichnet, daß
   die erste Zwischenschicht (22) den gleichen Leitungstyp wie die erste leitfähige Schicht (21) aufweist, jedoch eine höhere Dotierstoffkonzentration besitzt und die zweite Zwischenschicht (23) den gleichen Leitungstyp wie die zweite leitfähige Schicht (24) aufweist, jedoch eine höhere Dotierstoffkonzentration besitzt.
6. Anordnung nach einem der Aspekte 4 oder 5,
   dadurch gekennzeichnet, daß
   die erste oder die zweite Zwischenschicht (22, 23) eine Dicke zwischen einer Monolage und 30 nm aufweist.
7. Anordnung nach einem der Aspekte 4 bis 6,
   dadurch gekennzeichnet, daß
   die erste oder die zweite Zwischenschicht (22, 23) eine Dicke zwischen 4 und 12 nm aufweist.
8. Anordnung übereinander gestapelter Halbleiter-Diodenlaser mit:
   - einem Substrat (1), auf dem ein erster Diodenlaser (12) angeordnet ist;
   - einem zweiten Diodenlaser (13), der auf dem ersten Diodenlaser (12) angeordnet ist;
   - einer Kontaktschicht (6), die zwischen dem ersten Diodenlaser (12) und dem zweiten Diodenlaser (13) angeordnet ist,
   dadurch gekennzeichnet, daß
   die Kontaktschicht (6) so ausgebildet ist, daß eine Gitterfehlanpassung zwischen dem Substrat (1) und dem ersten Diodenlaser (12) durch eine Gitterfehlanpassung mit entgegengesetztem Vorzeichen zwischen dem Substrat (1) und der Kontaktschicht (6) kompensierbar ist.
9. Anordnung nach Aspekt 8,
   dadurch gekennzeichnet, daß
   das Substrat (1) eine erste Gitterkonstante (A1), der erste Diodenlaser (12) eine zweite Gitterkonstante (A2) und die Kontaktschicht (6) eine dritte Gitterkonstante (A3) aufweisen, wobei die Differenz von zweiter Gitterkonstante (A2) minus erster Gitterkonstante (A1) das gleiche Vorzeichen hat wie die Differenz von erster Gitterkonstante (A1) minus dritter Gitterkonstante (A3).
10. Anordnung nach einem der Aspekte 8 oder 9,
   dadurch gekennzeichnet, daß
   die Kontaktschicht (6) Galliumphosphid, Zinksulfid, Zinktellurid, Zinksulfidtellurid, Zinkselenid, Zinksulfidselenid, Indiumgalliumphosphid oder Indiumgalliumarsenphosphid enthält.

Nachfolgend wird die Erfindung anhand von Ausführungsbeispielen und Figuren näher erläutert. In den Figuren bezeichnen gleiche Bezugszeichen gleiche bzw. funktionsgleiche Elemente. In den Figuren zeigen:
- Figur 1: eine schematische Darstellung eines Schnittes durch einen Chip mit einem Halbleiterkörper mit zwei übereinander gestapelten Halbleiter-Diodenlasern;
- Figur 2: eine weitere schematische Darstellung eines Schnittes durch einen Chip mit einem Halbleiterkörper mit zwei übereinander gestapelten Halbleiter-Diodenlasern;
- Figur 3: eine schematische Darstellung eines Schnittes durch eine erste Ausgestaltung einer Kontaktschicht zwischen zwei übereinander gestapelten Halbleiter-Diodenlasern;
- Figur 4: eine schematische Darstellung eines Schnittes durch ein weiteres Ausführungsbeispiel einer Kontaktschicht zwischen zwei übereinander gestapelten Halbleiter-Diodenlasern.

Bei der Beschreibung der Ausführungsbeispiele ist jeweils ein entsprechendes komplementäres Ausführungsbeispiel mitumfaßt, bei dem sämtliche Dotierungen durch ihre komplementäre Dotierung ersetzt werden. Beispielsweise sind sämtliche p-Dotierungen durch n-Dotierungen zu ersetzen.

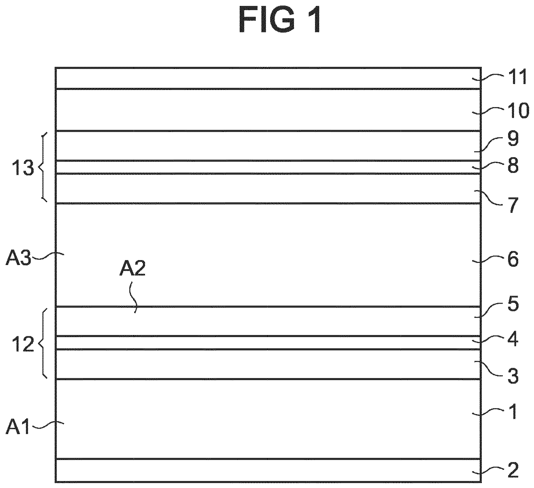

In Figur 1 ist ein Diodenlaser mit einem Substrat 1 dargestellt, welches mit einer ersten Kontaktierungsschicht 2 kontaktiert ist. Auf dem Substrat 1 ist auf einer der ersten Kontaktierungsschicht 2 abgewandten Oberfläche ein erster Diodenlaser 12 angeordnet. Dieser umfaßt beispielsweise eine erste Begrenzungsschicht 3 aus n-dotiertem Aluminiumgalliumarsenid (n-AlₓGa₁₋ₓAs) und eine zweite Begrenzungsschicht 5 aus p-dotiertem Aluminiumgalliumarsenid (p-AlₓGa₁₋ₓAs), zwischen denen eine erste aktive Laserschicht 4 angeordnet ist, die beispielsweise Galliumarsenid bzw. Indiumgalliumarsenid aufweist. Weiterhin kann die Laserschicht 4 mit p-Typ bzw. n-Typ Dotierstoff dotiert sein. Durch Wahl des Materials der Laserschicht 4 kann die Wellenlänge der emittierten Strahlung verändert werden. Ebenso sind Laser umfaßt, die aus anderen Materialsystemen mit beispielsweise Phosphiden oder Seleniden bestehen.

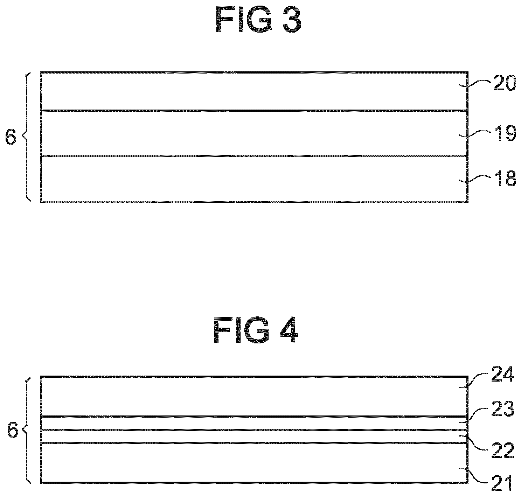

Auf der zweiten Begrenzungsschicht 5 ist eine Kontaktschicht 6 angeordnet. Die Kontaktschicht 6 wird in Zusammenhang mit Figur 3 und 4 näher erläutert. Auf der Kontaktschicht 6 ist ein zweiter Diodenlaser 13 angeordnet, der analog zu dem ersten Diodenlaser 12 aufgebaut ist und eine dritte Begrenzungsschicht 7 aus n-dotiertem Aluminiumgalliumarsenid (n-AlₓGa₁₋ₓAs), eine zweite aktive Laserschicht 8 und eine vierte Begrenzungsschicht 9 aus p-dotiertem Aluminiumgalliumarsenid (p-AlₓGa₁₋ₓAs) umfaßt. Auf dem zweiten Diodenlaser 13 ist eine Verbindungsschicht 10 und auf dieser eine zweite Kontaktierungsschicht 11 angeordnet.

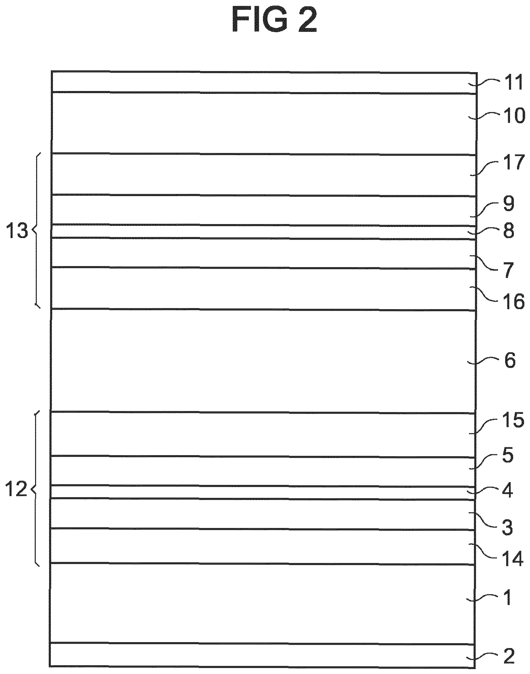

Bei dem in Figur 2 dargestellten Ausführungsbeispiel ist jeweils auf der von der aktiven Laserschicht 4, 8 abgewandten Seite der Begrenzungsschichten 3, 5, 7, 9 eine Mantelschicht 14, 15, 16, 17 angeordnet. Die Mantelschichten begünstigen die Wellenführung in den Diodenlasern 12, 13. Weiterhin kann eine Ladungsträgerinversion erleichtert werden, wodurch die Schwelle für den Laser reduziert wird.

Beispielsweise kann vorgesehen werden, daß die erste und zweite Mantelschicht 14, 15 einen Aluminiumanteil von etwa 30 % und die erste und zweite Begrenzungsschicht 3, 5 einen Aluminiumanteil von etwa 60 % aufweisen. Diese Ausgestaltung führt zu einer vorteilhaften Wellenführung in dem ersten Diodenlaser 12. Die dritte und vierte Mantelschicht 16, 17 weisen z.B. ebenfalls eine Aluminiumkonzentration von 30 % und die dritte und vierte Begrenzungsschicht 7 und 9 eine Aluminiumkonzentration von 60 % auf. Dies begünstigt die Wellenführung in dem zweiten Diodenlaser 13.

In Figur 3 ist die Kontaktschicht 6 dargestellt. Die Kontaktschicht 6 umfaßt eine erste leitfähige Schicht 18, die mit einem ersten Dotierstofftyp dotiert ist. Weiterhin umfaßt die Kontaktschicht 6 eine zweite leitfähige Schicht 20, die mit einem zweiten Dotierstofftyp dotiert ist. Der erste Dotierstofftyp ist dabei komplementär zu dem zweiten Dotierstofftyp gewählt. Weiterhin ist zwischen der ersten leitfähigen Schicht 18 und der zweiten leitfähigen Schicht 20 eine Zwischenschicht 19 angeordnet. In einem Ausführungsbeispiel ist die Zwischenschicht 19 beispielsweise undotiert, also intrinsisch. Dies hat den Vorteil, daß die Ladungsträger-Absorption und die Streuung von Ladungsträgern an ionisierten Störstellen im Übergangsbereich reduziert wird, da die Anzahl der Störstellen reduziert ist. Folglich ist der elektrische Widerstand der Kontaktschicht 6 reduziert.

Ein weiteres Ausführungsbeispiel sieht vor, daß die Zwischenschicht 19 mit dem ersten oder dem zweiten Ladungsträgertyp dotiert ist.

Hierbei wird die Dotierstoffkonzentration der Zwischenschicht 19 geringer gewählt als die Dotierstoffkonzentration der ersten leitfähigen Schicht 18 oder der zweiten leitfähigen Schicht 20.

Ein weiteres Ausführungsbeispiel der Kontaktschicht 6 ist in Figur 4 dargestellt. In diesem Fall umfaßt die Kontaktschicht 6 eine erste leitfähige Schicht 21, eine erste Zwischenschicht 22, die auf der leitfähigen Schicht 21 angeordnet ist, eine zweite Zwischenschicht 23, die auf der ersten Zwischenschicht 22 angeordnet ist und eine zweite leitfähige Schicht 24, die auf der zweiten Zwischenschicht 23 angeordnet ist. Beispielsweise handelt es sich bei der ersten leitfähigen Schicht 21 um eine p-dotierte Galliumarsenidschicht bzw. Aluminiumgalliumarsenidschicht. Weiterhin handelt es sich bei der ersten Zwischenschicht 22 um eine hoch-p-dotierte Galliumarsenidschicht und bei der zweiten Zwischenschicht 23 um eine hoch-n-dotierte Galliumarsenidschicht. Bei der zweiten leitfähigen Schicht 24 handelt es sich beispielsweise um eine n-dotierte Galliumarsenidschicht. Darüber hinaus sind folgende Materialien für die erste leitfähige Schicht 21, die erste Zwischenschicht 22, die zweite Zwischenschicht 23 und die zweite leitfähige Schicht 24 geeignet. Beispielsweise kann Indium-Gallium-Aluminium-Arsenid in der ersten leitfähigen Schicht 21, der ersten Zwischenschicht 22, der zweiten Zwischenschicht 23 und der zweiten leitfähigen Schicht 24 enthalten sein.

Wird die erste Zwischenschicht 22 und die zweite Zwischenschicht 23 mit einer Dicke zwischen einer Monolage und 50 nm - also beispielsweise 10 nm - gebildet, so bilden sich Quantentrog-ähnliche Strukturen (quantum well), die höher dotierbar sind, als Bulk-Material. Dadurch wird eine erhöhte Ladungsträgerdichte erreicht, die zu einer erhöhten Tunnelwahrscheinlichkeit und somit zu einem reduzierten Kontaktwiderstand führt.

Die Beschreibung des Ausführungsbeispiels ist nicht als Einschränkung auf Galliumarsenid zu verstehen. Die Schichtenfolge kann ebenso in entsprechender Weise durch Galliumnitrid, Zinkselenid oder Zinktellurid oder aus einer Verbindung gemäß der allgemeinen Formel (Zn,Mg,Cd) (S,Se,Te), wobei die Anteile der einzelnen Bestandteile auch gleich Null sein können, ersetzt werden.

Mit Bezug auf Figur 1 sieht eine Ausgestaltung der Erfindung vor, daß das Substrat 1 eine erste Gitterkonstante A1, der erste Diodenlaser 12 eine zweite mittlere Gitterkonstante A2 und die Kontaktschicht 6 eine dritte Gitterkonstante A3 aufweist. Wird zum Beispiel der Diodenlaser kompressiv durch das Substrat verspannt, wird die durch die Verspannung gespeicherte Energie in der gesamten Struktur zumindest teilweise reduziert, wenn die Kontaktschicht tensil durch das Substrat verspannt wird. Vorteilhaft ist dabei, daß die Kontaktschicht eine kleine Gitterkonstante als das Substrat besitzt, wenn der Laser eine größere Gitterkonstante als das Substrat aufweist. Im umgekehrten Fall ist es vorteilhaft, daß die Kontaktschicht eine größere Gitterkonstante als das Substrat besitzt, wenn der Laser eine kleinere Gitterkonstante als das Substrat aufweist. Dadurch wird die Verspannung in dem Diodenlaser 12 einschließlich Kontaktschicht aufgrund der Gitterfehlanpassung auf das Substrat 1 abgeschwächt. In entsprechender Weise kann die Kraft einer tensilen Gitterfehlanpassung teilweise kompensiert werden. Eine Kompensation findet folglich statt, wenn die Differenz von zweiter Gitterkonstante A2 minus erster Gitterkonstante A1 das gleiche Vorzeichen hat wie die Differenz von erster Gitterkonstante A1 minus dritter Gitterkonstante A3.

## Patentansprüche

1. Anordnung übereinander gestapelter Halbleiter-Diodenlaser mit:
- einem Substrat (1), auf dem ein erster Diodenlaser (12) angeordnet ist;
- einem zweiten Diodenlaser (13), der auf dem ersten Diodenlaser (12) angeordnet ist;
- einer Kontaktschicht (6), die zwischen dem ersten Diodenlaser (12) und dem zweiten Diodenlaser (13) angeordnet ist,
**dadurch gekennzeichnet, daß**
die Kontaktschicht (6) so ausgebildet ist, daß eine Gitterfehlanpassung zwischen dem Substrat (1) und dem ersten Diodenlaser (12) durch eine Gitterfehlanpassung mit entgegengesetztem Vorzeichen zwischen dem Substrat (1) und der Kontaktschicht (6) kompensierbar ist.

2. Anordnung nach Anspruch 1,
**dadurch gekennzeichnet, daß**
das Substrat (1) eine erste Gitterkonstante (A1), der erste Diodenlaser (12) eine zweite Gitterkonstante (A2) und die Kontaktschicht (6) eine dritte Gitterkonstante (A3) aufweisen, wobei die Differenz von zweiter Gitterkonstante (A2) minus erster Gitterkonstante (A1) das gleiche Vorzeichen hat wie die Differenz von erster Gitterkonstante (A1) minus dritter Gitterkonstante (A3).

3. Anordnung nach einem der Ansprüche 1 oder 2,
**dadurch gekennzeichnet, daß**
die Kontaktschicht (6) Galliumphosphid, Zinksulfid, Zinktellurid, Zinksulfidtellurid, Zinkselenid, Zinksulfidselenid, Indiumgalliumphosphid oder Indiumgalliumarsenphosphid enthält.

4. Anordnung nach einem der vorherigen Ansprüche,
**dadurch gekennzeichnet, daß**
die Kontaktschicht eine kleinere Gitterkonstante aufweist als das Substrat und der erste Diodenlaser eine größere Gitterkonstante aufweist als das Substrat.

5. Anordnung nach einem der Ansprüche 1 bis 3,
**dadurch gekennzeichnet, daß**
die Kontaktschicht eine größere Gitterkonstante aufweist als das Substrat und der erste Diodenlaser eine kleinere Gitterkonstante aufweist als das Substrat.

6. Anordnung nach einem der vorherigen Ansprüche,
**dadurch gekennzeichnet, daß**
die Kontaktschicht (6) eine erste leitfähige Schicht (18), die mit einem ersten Dotierstofftyp dotiert ist, umfasst und die Kontaktschicht (6) eine zweite leitfähige Schicht (20), die mit einem zweiten Dotierstofftyp dotiert ist, umfasst, wobei der erste Dotierstofftyp komplementär zu dem zweiten Dotierstofftyp gewählt ist.

7. Anordnung nach einem der vorherigen Ansprüche,
**dadurch gekennzeichnet, daß**
der zweite Diodenlaser analog zum ersten Diodenlaser aufgebaut ist.

## Claims

1. Arrangement of semiconductor diode lasers stacked on top of one another, having:
- a substrate (1) on which a first diode laser (12) is arranged;
- a second diode laser (13), which is arranged on the first diode laser (12);
- a contact layer (6) which is arranged between the first diode laser (12) and the second diode laser (13),
**characterized in that**
the contact layer (6) is formed in such a way that a lattice mismatch between the substrate (1) and the first diode laser (12) can be compensated for by a lattice mismatch of the opposite sign between the substrate (1) and the contact layer (6).

2. Arrangement according to claim 1,
**characterized in that**
the substrate (1) has a first lattice constant (A1), the first diode laser (12) has a second lattice constant (A2) and the contact layer (6) has a third lattice constant (A3), the difference formed by the second lattice constant (A2) minus the first lattice constant (A1) having the same sign as the difference formed by the first lattice constant (A1) minus the third lattice constant (A3).

3. Arrangement according to one of claims 1 or 2,
**characterized in that**
the contact layer (6) contains gallium phosphide, zinc sulphide, zinc telluride, zinc sulphide telluride, zinc selenide, zinc sulphide selenide, indium gallium phosphide or indium gallium arsenic phosphide.

4. Arrangement according to one of the previous claims,
**characterized in that**
the contact layer has a smaller lattice constant than the substrate and the first diode laser has a greater lattice constant than the substrate.

5. Arrangement according to one of claims 1 to 3,
**characterized in that**
the contact layer has a greater lattice constant than the substrate and the first diode laser has a smaller lattice constant than the substrate.

6. Arrangement according to one of the previous claims,
**characterized in that**
the contact layer (6) comprises a first conductive layer (18) doped with a first dopant type and the contact layer (6) comprises a second conductive layer (20) doped with a second dopant type, wherein the first dopant type is selected to be complementary with respect to the second dopant type.

7. Arrangement according to one of the previous claims,
**characterized in that**
the second diode laser is of similar structure to the first diode laser.

## Revendications

1. Agencement des diode lasers à semi-conducteurs empilés les uns sur les autres, avec:
- un substrat (1), sur lequel est disposée une première diode laser (12);
- une deuxième diode laser (13), laquelle est disposée sur la première diode laser (12);
- une couche de contact (6), laquelle est disposée entre la première diode laser (12) et la deuxième diode laser (13);
**caractérisé en ce que**
la couche de contact (6) est conçue de telle sorte qu'une mauvaise adaptation entre le substrat (1) et la première diode laser (12) peut être compensée par l'intermédiaire d'une discordance des réseaux cristallins, avec des signes opposés entre le substrat (1) et la couche de contact (6).

2. Agencement selon la revendication 1,
**caractérisé en ce que**
le substrat (1) présente une première constante de réseau cristallin (A1), la première diode laser (12) présente une deuxième constante de réseau cristallin (A2) et la couche de contact (6) présente une troisième constante de réseau cristallin (A3);
dans lequel la différence de la deuxième constante de réseau cristallin (A2) moins la première constante de réseau cristallin (A1) possède le même signe que la différence de la première constante de réseau cristallin (A1) moins la troisième constante de réseau cristallin (A3).

3. Agencement selon l'une des revendications 1 ou 2
**caractérisé en ce que**
la couche de contact (6) contient du phosphure de gallium, du sulfure de zinc, du tellure de zinc, du tellure de sulfure de zinc, du séléniure de zinc, du séléniure de sulfure de zinc, du phosphure de gallium et d'indium ou du phosphure d'arsenic, de gallium et d'indium.

4. Agencement selon l'une des revendications précédentes,
**caractérisé en ce que**
la couche de contact présente une constante de réseau cristallin plus petite que le substrat et la première diode laser présente une constante de réseau cristallin plus grande que le substrat.

5. Agencement selon l'une des revendications 1 à 3,
**caractérisé en ce que**
la couche de contact présente une constante de réseau cristallin plus grande que le substrat et la première diode laser présente une constante de réseau cristallin plus petite que le substrat.

6. Agencement selon l'une des revendications précédentes,
**caractérisé en ce que**
la couche de contact (6) comprend une première couche conductrice (18), laquelle est dopée avec un premier type de matières dopantes, et la couche de contact (6) comprend une deuxième couche conductrice (20), laquelle est dopée avec un deuxième type de matières dopantes;
dans lequel le premier type de matières dopantes est sélectionné de manière à être complémentaire avec le deuxième type de matières dopantes.

7. Agencement selon l'une des revendications précédentes,
**caractérisé en ce que**
la deuxième diode laser est structurée de manière similaire à la première diode laser.
